# EUROPÄISCHE PATENTSCHRIFT

(11) **EP 2 890 926 B1**
(45) Veröffentlichungstag und Bekanntmachung des Hinweises auf die Patenterteilung: **01.11.2017**
(21) Anmeldenummer: 13753318.8
(22) Anmeldetag: 28.08.2013
(51) Int. Cl.: F21V 19/00, F21S 4/28, F21V 23/06, H05K 1/14, H05K 3/36, H05K 3/32, F21Y 103/10, F21Y 115/10, F21Y 101/00

(54) **ANORDNUNG ZUR LICHTABGABE MIT MEHREREN LED-PLATINEN**
LIGHT-EMITTING ARRANGEMENT WITH A PLURALITY OF LED BOARDS
DISPOSITIF POUR L'ÉMISSION DE LUMIÈRE COMPRENANT PLUSIEURS PLATINES DE DEL

(30) Priorität: 28.08.2012 DE 202012103264 U
(43) Veröffentlichungstag der Anmeldung: 08.07.2015
(73) Patentinhaber: Zumtobel Lighting GmbH, 6850 Dornbirn (AT)
(72) Erfinder: KELLER, Katharina, 88161 Lindau (DE)
(74) Vertreter: Thun, Clemens
(86) Internationale Anmeldenummer: PCT/EP2013/067785
(87) Internationale Veröffentlichungsnummer: WO 2014/033154

(56) Entgegenhaltungen:
- US-A1- 2012 206 909
- US-B2- 6 882 111

## Beschreibung

Die vorliegende Erfindung betrifft eine Anordnung zur Lichtabgabe gemäß dem Oberbegriff des Anspruchs 1, welche mehrere nebeneinander angeordnete LED-Platinen sowie Mittel zum elektrischen Verbinden der Platinen aufweist.

Leuchtmittel auf LED-Basis haben sich zwischenzeitlich auch in der allgemeinen Beleuchtungstechnologie durchgesetzt. Mittlerweile sind zur Verfügung stehende LEDs derart leistungsstark, dass sie in nahezu sämtlichen Anwendungsgebieten klassische Lichtquellen wie Glühbirnen und Leuchtstofflampen ersetzen können. Da die Abmessungen einer einzelnen LED äußerst gering sind und eine derartige Lichtquelle im Wesentlichen als punktförmig angesehen wird, kommen üblicherweise eine Vielzahl von LEDs zum Einsatz, die dann entsprechend verteilt angeordnet sind, um eine längliche oder flächige Lichtabgabe zu erzielen.

Üblicherweise kommen dabei einzelne LED-Platinen zum Einsatz, auf denen jeweils mehrere LEDs angeordnet sind. Eine Platine selbst besteht dabei aus einem länglichen bzw. flächigen Trägerelement, z.B. einer Leiterplatte, mit entsprechenden Leitungen, die insbesondere in Form von Leiterbahnen ausgebildet sind und über welche eine Stromversorgung der LEDs erfolgt. Je nach dem, in welcher Form die Lichtabgabe einer Leuchte erfolgen soll, sind dann die Platinen über eine größere Fläche hinweg verteilt oder in Längsrichtung hintereinander angeordnet.

Die Strom- bzw. Energieversorgung der LED-Platinen erfolgt in der Regel über ein entsprechendes Betriebsgerät, welches bspw. innerhalb des Gehäuses der zugehörigen Leuchte angeordnet ist. Das Betriebsgerät stellt eine für den Betrieb der LEDs geeignete Versorgungsspannung oder einen entsprechenden konstanten Strom zur Verfuegung, der den Platinen dann über Zuführungsleitungen zugeführt wird. Dabei werden die Platinen untereinander elektrisch verbunden, sodass sich auf diese Weise ein geeigneter Stromkreis zur Energieversorgung aller LEDs ergibt.

Das elektrische Verbinden der nebeneinander oder hintereinander angeordneten LED-Platinen erfolgte bislang dadurch, dass an entsprechend einander zugewandten Positionen der Platinen, bspw. an den entsprechenden Stirnseiten Verbindungsdrähte angelötet wurden. Die Montage derartiger sog. Drahtbrücken ist nicht nur verhältnismäßig aufwendig sondern weist darüber hinaus auch den Nachteil auf, dass die Drähte und Kontakte zu Verschattungen führen können. Hierbei kann also die von den LEDs erzielte Lichtabgabe derart beeinträchtigt werden, dass letztendlich nicht mehr die in der Regel gewünschte homogene Lichtabgabe über die gesamte Lichtaustrittsfläche einer Leuchte hinweg erzielt wird.

Aus der US 6,882,111 B2 und der US 2012/0206909 A1 sind Beleuchtungsvorrichtungen bekannt, bei denen LED-Platinen über entsprechende Verbindungselemente miteinander verbunden werden.

Der vorliegenden Erfindung liegt die Aufgabenstellung zugrunde, eine neuartige Lösung zum entsprechenden Verbinden derartiger LED-Platinen anzugeben, bei der insbesondere die Nachteile hinsichtlich der Montage sowie möglichst auch der Lichtabgabe vermieden werden.

Die Aufgabe wird durch eine Anordnung zur Lichtabgabe mit den Merkmalen des Anspruchs 1 gelöst. Vorteilhafte Weiterbildungen der Erfindung sind Gegenstand der abhängigen Ansprüche.

Die erfindungsgemäße Lösung beruht auf dem Gedanken, die Maßnahmen, über welche die elektrische Verbindung zweier benachbarter Platinen erzielt wird, derart auszugestalten, dass anstelle des Auflötens der Drahtbrücken zwei Platinen in einfacher Weise durch das Anordnen lösbarer Verbindungsmittel miteinander verbunden werden. Es handelt sich hierbei um Verbindungsmittel, welche mit den Platinen verrastet oder verklemmt werden und hierbei die elektrische Verbindung sicherstellen. Hierzu weisen die Verbindungsmittel entsprechende Schnapp- oder Rastelemente auf.

Erfindungsgemäß wird also eine Anordnung zur Lichtabgabe mit mehreren nebeneinander angeordneten LED-Platinen sowie Verbindungsmitteln zum elektrischen Verbinden benachbarter LED-Platinen vorgeschlagen, wobei die Verbindungsmittel jeweils lösbar mit den LED-Platinen verbindbar sind. Die Verbindungsmittel weisen dabei jeweils ein flächiges, als Leiterplatte ausgebildetes Element auf, auf dem Leiterbahnen angeordnet sind, wobei das flächige Element an seiner den Leiterbahnen abgewandten Seite Mittel zur Befestigung an einem Trägerelement, beispielsweise eine Leuchtenwanne oder einem Leuchtengehäuse aufweist. Zusätzlich ist vorgesehen, dass die Verbindungsmittel mit den LED-Platinen verrastbar oder verklemmbar sind, wobei die Verbindungsmittel Stirnseiten der LED-Platinen übergreifende Schnapp- oder Rastelemente aufweisen.

Die Leiterbahnen erstrecken sich dann letztendlich von Platine zu Platine und bewirken die erforderliche elektrische Verbindung. Durch die Mittel zur Befestigung an einem Trägerelement ist es dann möglich, dass über die Verbindungsmittel zugleich auch eine Befestigung bzw. eine Lagerung der LED-Platinen erfolgt.

Gemäß einem bevorzugten Ausführungsbeispiel sind hierbei die Verbindungsmittel derart ausgestaltet, dass sie die Platinen jeweils an der den LEDs gegenüberliegenden Seite kontaktieren. Hierdurch wird der Vorteil erzielt, dass der die LEDs umgebende Bereich auf der Lichtabstrahlseite frei von derartigen Mitteln gehalten werden kann. Dementsprechend besteht auch nicht mehr die Gefahr, dass durch derartige Verbindungsmittel eine Verschattung auftritt, welche die angestrebte homogene Lichtabgabe negativ beeinträchtigen könnte.

Letztendlich wird durch diese erfindungsgemäßen Maßnahmen nicht nur die Montage der LED-Platinen vereinfacht. Auch die lichttechnischen Eigenschaften der Anordnung zur Lichtabgabe können durch die vorteilhaften Weiterbildungen optimiert werden.

Nachfolgend soll die Erfindung anhand der beiliegenden Zeichnung näher erläutert werden. Es zeigen:
Figur 1 eine Leuchte, bei der mehrere LED-Platinen als Leuchtmittel zum Einsatz kommen;
Figuren 2 und 3 Ansichten einer ersten Ausführungsform erfindungsgemäßer Verbindungsmittel zum elektrischen Verbinden zweier benachbarter Platinen;
Figur 4 eine zweite Ausführungsform erfindungsgemäßer Verbindungsmittel und
Figuren 5a und 5b eine dritte Variante von Verbindungsmitteln.

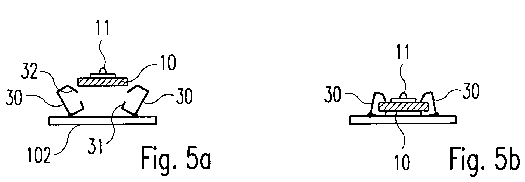

Zu beachten ist dabei, dass die in den Figuren 5a und 5b gezeigte dritte Variante eine nicht vom Schutzumfang der Ansprüche umfasste Variante ist, die jedoch dem besseren Verständnis der Erfindung dient.

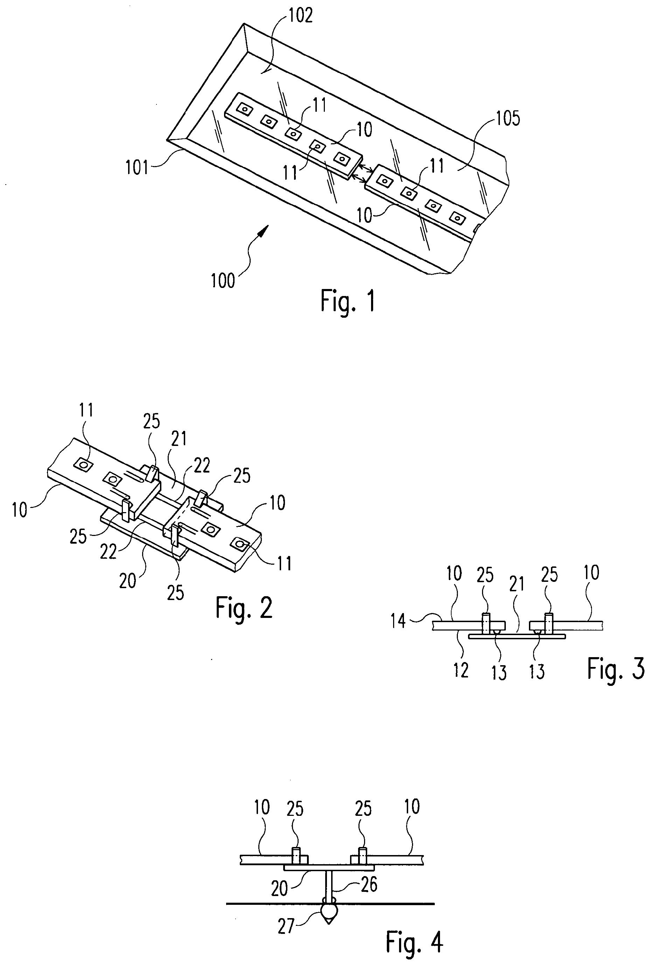

Figur 1 zeigt als grundsätzliches Anwendungsbeispiel der vorliegenden Erfindung eine längliche Leuchte 100, bei der als Leuchtmittel LED-Platinen 10 zum Einsatz kommen. Die Leuchte 100 weist ein längliches, kastenförmiges Gehäuse 101 auf, dessen Bodenfläche 102 gleichzeitig auch der Lagerung der LED-Platinen 10 dient. Die der Bodenfläche 102 gegenüberliegende Öffnung des Leuchtengehäuses 101 bildet die Lichtaustrittsfläche, über welche die Lichtabgabe erfolgt. Diese ist im dargestellten Ausführungsbeispiel durch eine lichtdurchlässige, vorzugsweise lichtstreuende Scheibe 105 abgedeckt. Mit Hilfe der Scheibe 105 soll eine Vermischung bzw. Streuung des von den LEDs 11 abgegebenen Lichts erfolgen, sodass diese nicht mehr als einzelne, punktförmige Lichtquellen wahrgenommen werden sondern stattdessen eine gleichmäßige Lichtabgabe im Wesentlichen über die gesamte Lichtaustrittsfläche hinweg erfolgt. Selbstverständlich könnten dabei alternativ oder ergänzend zu der lichtdurchlässigen Scheibe 105 auch andere Mittel zur Beeinflussung der Lichtabgabe vorgesehen sein. Auch ist die vorliegende Erfindung keinesfalls auf derartige längliche Leuchten beschränkt, bei denen die LED-Platinen 10 hintereinander angeordnet sind. In gleicher Weise wäre z.B. auch eine flächige bzw. matrixartige Anordnung der Platinen denkbar.

Nicht dargestellt sind bei dem Ausführungsbeispiel von Figur 1 die eigentlichen Mittel zur Stromversorgung der LED-Platinen 10. Hierfür ist üblicherweise innerhalb des Gehäuses 101 zumindest ein Betriebsgerät angeordnet, welches die allgemeine Netz-Versorgungsspannung umsetzt und die LED-Platinen 10 versorgt. Dabei ist vorzugsweise vorgesehen, die Platinen 10 mit einem konstanten Strom zu versorgen, der ggf. pulsweitenmoduliert ist.

Ferner sind elektrische Verbindungen zwischen den Platinen 10 in Figur 1 lediglich schematisch durch die Doppelpfeile angedeutet. In Realität müssen die Platinen 10 miteinander verbunden werden, um einen geschlossenen Stromkreis zur Versorgung der LEDs 11 sicherzustellen. Die LEDs 11 auf einer einzelnen Platine 10 sind untereinander durch hier nicht näher dargestellte Leiterbahnen und/oder andere Leitungen verbunden. Die Verbindung zwischen den Platinen 10 untereinander erfolgte bislang in erster Linie durch angelötete Drahtbrücken, welche erst nach der Montage der LED-Platinen 10 in dem Leuchtengehäuse 101 oder an einem in dem Gehäuse 101 zu befestigenden Trägerelement angebracht werden konnten. Dies war nicht nur mit einem verhältnismäßig hohen Aufwand verbunden sondern führte auch dazu, dass zumindest die Lichtabgabe der sich in der Nähe der Drahtbrücken befindlichen LEDs teilweise aufgrund von Verschattungen beeinträchtigt wurde. Mit Hilfe den nachfolgend beschriebenen Lösungen zur elektrischen Verbindung der Platinen 10 untereinander können derartige Nachteile vermieden werden.

Die Figuren 2 und 3 zeigen dabei zunächst ein erstes Ausführungsbeispiel der vorliegenden Erfindung, wobei in den Figuren 2 und 3 keine Mittel zur Befestigung an einem Trägerelement gezeigt. Grundgedanke der Erfindung ist dabei, dass die elektrische Verbindung der Platinen 10 untereinander nicht - wie bislang üblich - durch Drahtbrücken erfolgt, sondern stattdessen mit Hilfe von lösbaren Verbindungsmitteln vorgenommen wird, welche vorzugsweise die Platinen 10 jeweils an der Unterseite bzw. der den LEDs 11 gegenüberliegenden Seite kontaktieren. Ein Voraussetzung für das Kontaktieren an der den LEDs 11 gegenüberliegenden Seite ist, dass tatsächlich auch an der Unterseite 12 der Platinen 10 entsprechende Kontakte 13 zur Verfügung stehen. Diese sind in Figur 3 erkennbar und werden dadurch erhalten, dass eine Anbindung zu den an der Oberseite 14 der Platinen 10 verlaufenden Leiterbahnen geschaffen wird. Dies kann bspw. dadurch erfolgen, dass eine entsprechende Bohrung in die Platine 10 eingebracht und Durchkontaktierungen - z.B. durch Auffüllen der Bohrungen durch ein leitendes Material - geschaffen werden. Die eigentlichen Kontakte 13 können dann durch angelötete SMD-Teile oder durch sog. Lötbubbels geschaffen werden. In jedem Fall sind dann also an den Stirnbereichen der Platinen 10 an der Unterseite jeweils Kontakte 13 geschaffen, über welche die Platinen 10 kontaktiert werden können.

Zur Verbindung zweier benachbarter Platinen 10 ist dann gemäß dem ersten Ausführungsbeispiel vorgesehen, dass die Verbindungsmittel 20 ein flächiges, als Leiterplatte ausgebildetes Element 21 aufweisen. Auf dieser Leiterplatte 20 verlaufen zwei Leiterbahnen 22, welche jeweils die Kontakte 13 der LED-Platinen 10 kontaktieren und auf diese Weise eine elektrische Verbindung zwischen den beiden benachbarten Platinen 10 herstellen. Offensichtlich ist bei dieser Lösung nicht mehr erforderlich, an den Oberseiten der LED-Platinen 10 Drahtbrücken anzulöten, sodass das zuvor beschriebene Problem der aufwendigen Montage und möglichen Verschattung der Lichtabgabe vermieden wird. Die die Leiterplatte 21 ist hierbei vorzugsweise derart dünn bemessen, dass es die weiteren Maßnahmen zur mechanischen Befestigung der Platinen 10 an dem Leuchtengehäuse oder einem entsprechenden anderen Trägerelement nicht beeinträchtigt. Dadurch, dass die Leiterplatte 21 sehr dünn gehalten wird, ist sichergestellt, dass diese Maßnahmen nach wie vor in üblicherweise zum Einsatz kommen können, d.h., in dieser Hinsicht ist auch keine entsprechende Anpassung erforderlich.

Die lösbare Verbindung mit den LED-Platinen 10 wird bei dem Ausführungsbeispiel der Figuren 2 und 3 dadurch ermöglicht, dass an den Leiterplatte 21 vier Rast- bzw. Schnapphaken 25 ausgebildet sind. Wie den Darstellungen entnommen werden kann, übergreifen diese Schnapphaken 25 jeweils die Längsseiten der LED-Platinen 10 und fixieren diese. Hierdurch wird nicht nur eine zuverlässige Verbindung zwischen den Leiterbahnen 22 und den Kontakten 13 sichergestellt sondern die Platinen 10 werden auch zusätzlich sicher gehalten, sodass ggf. auch auf weitere Maßnahmen zur mechanischen Befestigung der Platinen 10 verzichtet werden kann.

Die Halterung der LED-Platinen 10 über die Verbindungsmittel 20 ist insbesondere dann zur Montage der Platinen 10 in dem Leuchtengehäuse ausreichend, wenn die Verbindungsmittel 20 selbst an dem Gehäuse befestigt werden. Bei einer alternativen Ausführungsform gemäß Figur 4 ist hierzu vorgesehen, dass an der den Leiterbahnen 22 gegenüberliegenden Seite des plattenförmigen Elements 21, also an dessen Unterseite ein Steg 26 angeordnet ist, der über entsprechende Rast- oder Schnappmittel 27 mit einem Leuchtengehäuse verbunden und dort verankert wird. Im dargestellten Ausführungsbeispiel ist hierzu vorgesehen, dass der Steg 26 mit seinem Endbereich in eine geeignet Ausnehmung des Gehäusebodens eingesetzt und dort verrastet wird. Die Befestigung der Platinen 10 an dem Verbindungsmittel 20 selbst erfolgt wiederum über die bereits zuvor beschriebenen Schnapp- bzw. Rastarme 25.

Eine dritte Variante von Verbindungsmitteln ist in den Figuren 5a und 5b dargestellt. Anstelle eines flächigen Trägerelements mit darauf vorgesehenen Leiterbahnen kommen nunmehr zwei einander gegenüberliegende Federelemente 30 zu Einsatz, welche entsprechend der Darstellung im Querschnitt etwa C-förmig ausgebildet sind. Diese Federelemente 30 bestehen aus einem elektrisch leitenden Material und sind im unteren Bereich schwenkbar an dem Träger, also bspw. an dem Leuchtengehäuseboden 102 befestigt. Die unteren Endbereiche der Federelemente 30 bilden hierbei einen leicht nach oben gerichteten Verbindungssteg 31, der wiederum in Anlage gegen die zuvor beschriebenen Kontakte 13 der LED-Platinen 10 gelangt und für die elektrische Verbindung sorgt. Der obere, ebenfalls stegartige Bereich 32 der Federelemente 30 hingegen dient dazu, nach Aufsetzen der LED-Platine 10 und entsprechendem Verschwenken der Federelemente 30 gegen die Oberflächen der Platine 10 zu drücken.

Wie in den Figuren 5a und 5b dargestellt ist, werden also die Platinen 10 von der Oberseite her aufgesetzt, was das Verschwenken der Federelemente 30 zur Folge hat. Dabei gelangen nicht nur die unteren Verbindungsstege 31 in Anlage gegen die Anschlusskontakte 13 der Platinen 10 sondern das Verschwenken hat auch zur Folge, dass die oberen Stege 32 gegen die Oberseiten der Platinen 10 gedrückt werden. Selbstverständlich erstrecken sich diese Verbindungselemente 30 lediglich in den jeweiligen Stirnbereich der miteinander zu verbindenden Platinen 10, sie beeinträchtigen also wiederum nicht die Lichtabgabe der LEDs 11. Ferner wird zusätzlich der Vorteil erreicht, dass die Montage der LED-Platinen 10 sehr einfach und schnell erfolgen kann, da weder ein mechanisches zusätzliches Befestigen an dem Leuchtengehäuse zwingend erforderlich ist noch aufwendig nachträglich Drahtbrücken zum elektrischen Verbinden der Platinen verlötet werden müssen.

## Patentansprüche

1. Anordnung zur Lichtabgabe mit mehreren nebeneinander angeordneten LED-Platinen (10) sowie Verbindungsmitteln (20) zum elektrischen Verbinden benachbarter LED-Platinen (10), wobei die Verbindungsmittel (20) jeweils lösbar mit den LED-Platinen (10) verbindbar sind und jeweils ein flächiges, als Leiterplatte ausgebildetes Element (21) aufweisen, auf dem Leiterbahnen (22) angeordnet sind, wobei das flächige Element (21) an seiner den Leiterbahnen (22) abgewandten Seite Mittel zur Befestigung (26) an einem Trägerelement, beispielsweise eine Leuchtenwanne oder einem Leuchtengehäuse aufweist,
**dadurch gekennzeichnet,**
**dass** die Verbindungsmittel (20) mit den LED-Platinen (10) verrastbar oder verklemmbar sind, wobei die Verbindungsmittel (20) Stirnseiten der LED-Platinen (10) übergreifende Schnapp- oder Rastelemente (25) aufweisen.

2. Anordnung nach Anspruch 1,
**dadurch gekennzeichnet,**
**dass** die Verbindungsmittel (20) die LED-Platinen an der den LEDs (11) gegenüberliegenden Seite kontaktieren.

3. Leuchte mit einer Anordnung zur Lichtabgabe nach einem der vorherigen Ansprüche.

## Claims

1. Arrangement for emitting light, comprising a plurality of LED boards (10) arranged next to one another, and connection means (20) for interconnecting adjacent LED boards (10), wherein the connection means (20) are connected in a detachable manner to the LED boards (10), and comprise a flat element (21) in the form of a PCB arranged on the conductor tracks (22), wherein the flat element (21) comprises, for example, a luminaire cover or a luminaire housing, on its side facing away from the conductor tracks (22) for the fastening (26) to a carrier element,
**characterized in that**
the connection means (20) may be locked or clamped with the LED boards (10), wherein the connection means (20) have snap-in or latching elements (25) overlapping the front sides of the LED boards (10).

2. Arrangement according to claim 1,
**characterized in that**
the connection means (20) contact the LED boards on the side opposite the LEDs (11).

3. Luminaire with an arrangement for emitting light according to one of the preceding claims.

## Revendications

1. Dispositif d'émission de lumière avec plusieurs platines LED (10) juxtaposées ainsi que des moyens de connexion (20) pour la connexion électrique de platines LED (10) voisines, les moyens de connexion (20) pouvant être respectivement connectés de façon détachable aux platines LED (10), et présentant respectivement un élément (21) plat, constitué en tant que circuit imprimé, sur lequel sont disposées des pistes conductrices (22), l'élément (21) plat présentant, sur son côté éloigné des pistes conductrices (22), des moyens pour la fixation (26) sur un élément de support, par exemple une vasque de luminaire ou un boîtier de luminaire,
**caractérisé en ce que**
les moyens de connexion (20) peuvent être assemblés aux platines LED (10) par encliquetage ou serrage, les moyens de connexion (20) présentant des éléments d'enclenchement ou d'encliquetage (25) qui s'agrippent par le haut des côtés frontaux des platines LED (10).

2. Dispositif selon la revendication 1,
**caractérisé en ce que**
les moyens de connexion (20) entrent en contact avec les platines LED sur le côté opposé aux LED (11).

3. Luminaire avec un dispositif d'émission de lumière selon l'une des revendications précédentes.
